# EUROPÄISCHE PATENTSCHRIFT

(11) **EP 1 261 753 B1**
(45) Veröffentlichungstag und Bekanntmachung des Hinweises auf die Patenterteilung: **24.06.2009**
(21) Anmeldenummer: 01923616.5
(22) Anmeldetag: 01.03.2001
(51) Int. Cl.: C23C 16/04, B05D 7/24, C03C 17/00

(54) **MASCHINE ZUM BESCHICHTEN VON HOHLKÖRPERN**
MACHINE FOR COATING HOLLOW BODIES
MACHINE SERVANT A REVETIR DES CORPS CREUX

(30) Priorität: 03.03.2000 DE 10010642
(43) Veröffentlichungstag der Anmeldung: 04.12.2002
(73) Patentinhaber: Tetra Laval Holdings & Finance SA, 1009 Pully (CH)
(72) Erfinder: MOORE, Rodney, Gardener, MA 01440 (US); SMITH, Hugh, Brampton, Ontario L6Z IB9 (CA); LÜTTRINGHAUS-HENKEL, Andreas, 64289 Darmstadt (DE)
(74) Vertreter: Weber, Roland
(86) Internationale Anmeldenummer: PCT/EP2001/002292
(87) Internationale Veröffentlichungsnummer: WO 2001/066818

(56) Entgegenhaltungen:
- WO-A-99/17334
- US-A- 5 849 366

## Beschreibung

Die Erfindung betrifft eine Maschine zum gleichzeitigen Beschichten der inneren Oberfläche mehrerer Hohlkörper, die auf einer im wesentlichen ebenen Hohlkörperträgerplatte so gehalten sind, daß jeweils ein an einer etwa ebenen Rohrstützplatte befestigtes Gaszuführrohr für Prozeßgas in den Hohlkörper einführbar und die aus Träger- und parallel dazu angeordneter Stützplatte bestehende Einheit in die jeweilige evakuierbare Behandlungskammer hinein- sowie aus dieser herausbewegbar ist, wobei die Behandlungskammer für jeden Hohlkörper mit einer Mikrowelleneinheit mit Resonator bestückt ist.

Um Kunststoff-Hohlkörper, zum Beispiel PET-Flaschen, gegen niedermolekulare Gase, wie zum Beispiel Sauerstoff, undurchlässig zu machen, ist es bekannt, die PET-Flaschen innen mit einer Beschichtung, zum Beispiel einer SiOₓ-Schicht, zu versehen, weil diese gute Barriereeigenschaften gegen niedermolekulare Gase hat. Für diese Innenbeschichtung wird ein Prozeßgasgemisch über ein Gaszuführrohr in das Innere der PET-Flasche, welches vorher evakuiert war, eingeblasen, und mit Hilfe von Mikrowellenenergie kann man dieses Plasma zünden und die inneren Oberflächen der Flasche beschichten.

Im Labor und auch schon in größerem Maßstab hat man PET-Flaschen über den Einsatz von Mikrowellenenergie beschichtet. Es ist auch schon bekannt, eine Mehrzahl von Hohlkörpern gleichzeitig innen zu beschichten, wobei man eine Maschine ähnlich der eingangs bezeichneten Art verwendet siehe z.B. WO 99/17334 und US-5,849,366. Bei dieser bekannten Maschine werden Kunststoffflaschen mit ihrer Öffnung nach unten so auf eine ebene Hohlkörperträgerplatte aufgesetzt, daß der jeweilige Flaschenhals von der Trägerplatte gehalten wird. Die Trägerplatte selbst steht in der Waagerechten wie ein Tablett, und eine Reihe von Flaschen erstreckt sich vertikal derart mit ihrem Boden nach oben, daß von unten ein vertikal hochstehendes Gaszuführrohr aus einer ebenfalls waagerecht angeordneten, ebenen Rohrstützplatte durch den Flaschenhals von unten nach oben eingeführt werden kann. Die Gaszuführrohre sind ebenso in einer Reihe vertikal auf der waagerechten Rohrstützplatte angeordnet wie die Reihe der zu beschichtenden Flaschen. Für den Betrieb muß die Trägerplatte aus einer ersten waagerechten Position in eine zweite waagerechte Position gefahren werden, in der zweiten Position die Rohrstützplatte vertikal in Verbindung zu der Trägerplatte gefahren werden, und die aus diesen beiden Platten bestehende Einheit wird nach ihrem Zusammenfahren weiter in vertikaler Richtung in eine evakuierbare Behandlungskammer hinein- und nach der Behandlung herausbewegt. Danach wird auch die Trägerplatte wieder horizontal zurückgefahren, und es werden besondere Einrichtungen benötigt, um die beschichteten Flaschen von der Trägerplatte zu lösen und von dieser abzustreifen. Der Platzbedarf einer solchen Beschichtungsmaschine ist infolge der waagerechten Anordnung der Trägerplatte und der Rohrstützplatte groß. Außerdem ist die Entladung aufwendig.

Der Erfindung liegt daher die Aufgabe zugrunde, die Leistung der eingangs beschriebenen Maschine zu steigern und dennoch einen kompakteren Gesamtaufbau der Maschine mit entsprechend geringerem Platzbedarf zu ermöglichen. Dabei sollen insbesondere mehr Hohlkörper pro Maschineneinheit bei einem Betriebsdurchgang beschichtbar sein.

Diese Aufgabe wird erfindungsgemäß dadurch gelöst, daß
1. die Hohlkörperträgerplatte mit matrixartig nebeneinander angeordneten Befestigungsplätzen und die Rohrstützplatte mit zu diesen Befestigungsplätzen jeweils korrespondierend angeordneten Gaszuführrohren vertikal ausgerichtet sind,
2. ebenfalls vertikal ausgerichtet eine Trennwand mit entsprechend passend matrixartig nebeneinander angeordneten Löchern mit Quarzfenstem am Maschinenrahmen befestigt ist,
3. die Träger- und die Stützplatte mit einem Antrieb für den horizontale Bewegung in die Maschine hinein und zum Be- und Entladen aus der Maschine heraus vorgesehen ist,
4. die Trennwand, die Hohlkörperträgerplatte und die Rohrstützplatte mit ihren Funktionszubehörteilen ein erstes Modul bilden,
5. spiegelbildlich zu dem ersten Modul ein zweites Modul entsprechenden Aufbaues am Maschinenrahmen befestigt ist und
6. daß sich die matrixartig angeordneten Mikrowelleneinheiten zwischen den Modulen befinden.

Zum Einsparen von Platz werden Maschinen häufig hoch gebaut. Bei der Beschichtungsmaschine gemäß der Erfindung werden zum Beispiel alle Pumpen vertikal oben auf den Maschinenrahmen aufgesetzt. Wenn der horizontale Platzbedarf durch das vertikale Ausrichten sowohl der Hohlkörperträgerplatte als auch der Rohrstützplatte verringert ist, können die Rohrleitungen von den Pumpen zu den einzelnen Einheiten kürzer werden. Der durch die verkleinerte horizontale Baufläche der Maschine zur Verfügung stehende Raum oben auf dem Maschinenrahmen ist groß genug, um alle Vakuumaggregate aufzusetzen. Die einzelnen zu versorgenden Kammern und Räume liegen aber näher aneinander mit der Folge der kürzeren Versorgungsleitungen.

Matrixartig können sowohl die Hohlkörper auf der Trägerplatte als auch die Gaszuführrohre auf der Rohrstützplatte Reihe neben Reihe angeordnet sein. Auf kleinem Raum sind damit viele Bearbeitungsplätze möglich.

Wenn außerdem jedes Modul mit einer stationären Trennwand versehen ist, die aus den gleichen platzsparenden Gründen ebenfalls vertikal ausgerichtet ist, kann auch hier eine große Anzahl von Löchern mit Quarzfenstern pro Flächeneinheit vorgesehen sein. Die Quarzfenster erlauben die Abtrennung eines zum Beispiel evakuierbaren Raumes einerseits von einem anderen zum Beispiel unter Atmosphärendruck stehenden Raum andererseits. Gleichzeitig sind die Quarzfenster aber für die Mikrowellenenergie durchlässig. Auf diese Weise können gasdicht Leitungen und Antennen von einem Versorgungsraum in einen evakuierbaren Behandlungsraum geführt werden. Eine solche Trennwand kann massiv ausgestaltet werden und verhältnismäßig große Kräfte aufnehmen. Diese ergeben sich aus dem Atmosphärendruck außen und dem Vakuum im Inneren der Behandlungskammer.

Als Antrieb für die Trägerplatte und die Stützplatte können Spindeln, Gleitschienen, Rolleinrichtungen und Kugellager verwendet werden. Zum Be- und Entladen der Hohlkörperträgerplatte muß diese aus der Maschine herausgezogen werden, damit sie für Bestückungseinheiten mit Hohlkörpern gut zugänglich ist. Vorzugsweise können zusätzliche Antriebe vorgesehen oder derselbe Antrieb benutzt werden, um die Trägerplatte und die Stützplatte als eine Einheit relativ zu der festen Trennwand zu verfahren und eine gasdicht abgeschlossene Behandlungskammer zu bilden. Eine solche geschlossene Kammer ist natürlich nicht mit Hohlkörpern zu bestücken. Hierfür muß sie erst geöffnet werden, wobei auch der Antrieb zum Herausfahren der Platten in horizontaler Richtung eingeschaltet werden muß.

Wenn man den Aufbau so gestaltet, daß erfindungsgemäß die Trennwand, die Hohlkörperträgerplatte und die Rohrstützplatte mit ihren Funktionszubehörteilen ein erstes Modul bilden, dann kann man nach der Lehre der Erfindung spiegelbildlich zu diesem ein entsprechend aufgebautes zweites Modul am Maschinenrahmen befestigen und beide Module von möglichst vielen dann nur einmal vorhandenen Versorgungseinrichtungen versorgen lassen. Vorzugsweise befinden sich dabei erfindungsgemäß die matrixartig angeordneten Mikrowelleneinheiten zwischen den Modulen.

Unter Funktionszubehörteilen für den Aufbau des jeweiligen Moduls gehören Befestigungselemente, Versorgungsleitungen, bewegliche und feste Maschinenelemente und dergleichen. Für den Aufbau einer Beschichtungsmaschine gemäß der Erfindung kann man diese Zubehörteile für jedes Modul gleich ausgestalten und an jedem Modul an entsprechender Stelle in gleicher Weise installieren. Dadurch lassen sich die Herstellungs- und Wartungskosten drastisch verringern.

Auf engstem Raum ist eine Beschichtungsmaschine durch die erfindungsgemäßen Maßnahmen sehr kompakt aufbaubar. Die gesamte Maschine benötigt einen geringen Platzbedarf im Vergleich zu den bekannten Maschinen mit der horizontal angeordneten Hohlkörperträgerplatte, die horizontal in ihre Arbeitsposition vorgefahren und nach der Verarbeitung wieder zurückgefahren wird. Auf verhältnismäßig geringem vertikalen Platz können viele Bearbeitungsstationen matrixartig auf einer Platte angeordnet und untergebracht werden, so daß sich eine leistungsstarke Beschichtungsmaschine ergibt.

Die Investitionskosten wirken sich auch stark bei der Anordnung und dem Aufbau der Pumpen aus. Leichter zugänglich als bei großflächigen Maschinen lassen sich die Vakuumaggregate auf den Maschinenrahmen aufsetzen, und die Auslastung der Pumpen kann beinahe verdoppelt werden, denn es genügt eine Vakuumeinheit für zwei Module, wie vorstehend beschrieben. Dabei wird nicht ausgeschlossen, daß auch eine größere Anzahl von Modulen an einem entsprechend ausgestalteten Maschinenrahmen untergebracht werden kann, zum Beispiel vier oder sechs Module, die sternartig um eine Mikrowellenversorgung herum angeordnet werden.

Die Mikrowelleneinheiten stellen ein Paket von im Abstand zueinander angeordneten Gehäusen mit anschließenden Auskopplungselementen und Hohlleitern dar, die matrixartig in großer Anzahl pro Flächeneinheit auf einer vertikalen Platte anbringbar sind. Wichtig ist, daß bei entsprechend engem Zusammenbau zwei Module von einem Generator die Mikrowellenenergie wahlweise in das eine Modul (zum Beispiel nach links) und danach in das andere Modul (zum Beispiel nach rechts) eingeleitet werden kann. Man braucht dann für zwei korrespondierende (bzw. in etwa spiegelbildlich angeordnete) Stationen jeweils nur eine einzige Mikrowellenquelleneinheit.

Durch die vertikale Ausrichtung von Hohlkörperträgerplatte, auf welcher die Hohlkörper dann so angeordnet sind, daß ihre Längsmittelachse sich im wesentlichen horizontal erstreckt, und Rohrstützplatte läßt sich nach dem Beschichtungsvorgang, nach welchem die Hohlkörperträgerplatte in die Be- und Entladeposition herausbewegt worden ist, die Entladung leicht bewerkstelligen. Es genügt das Einfahren von Auswerfern, um die beschichteten Hohlkörper von der Trägerplatte zu entfernen, die dann automatisch in einen darunter befindlichen Sammelbehälter fallen können.

Besonders günstig ist es, wenn man statt nur einer insgesamt zwei Hohlkörperträgerplatten pro Modul verwendet. Solange sich die eine davon in der Vakuumkammer befindet, kann die andere außerhalb be- und entladen werden. Im Zuge des Einfahrens in die (bzw. des Ausfahrens aus der) Vakuumkammer werden die Platten dann jeweils um ihre Vertikalachse gedreht, um die Hohlkörper in die richtige Position für die Beschichtung zu bringen.

Besonders vorteilhaft ist es erfindungsgemäß ferner, wenn für beide Module eine gemeinsame Kühlversorgung vorgesehen ist. Zum Temperieren der Mikrowelleneinheiten und insbesondere deren Gehäuse mit Stromversorgung sind diese zweckmäßig in einer Kühlkammer anzuordnen. Wenn man nun die Gehäuse der einzelnen Einheiten im Abstand voneinander Reihe neben Reihe matrixartig anordnet und Belüftungsspalte und -schlitze in ausreichender Menge und Größe vorsieht, dann kann man das gesamte Paket von Mikrowelleneinheiten zwischen zwei Modulen in einer Klimakammer zusammenfassen, welche überraschend eine gemeinsame Kühlversorgung darstellt. An jedem Punkt einer solchen Klimakammer können die Temperaturen gewünschtenfalls präzise gemessen und gesteuert werden.

Ähnlich vorteilhaft ist es, wenn man den modulartigen Aufbau gemäß der Erfindung dafür ausnutzt, daß für beide Module (gegebenenfalls für eine entsprechend größer Anzahl der eingesetzten Module) eine gemeinsame Gasversorgung vorgesehen ist. Unter dieser Versorgung ist die des Prozeßgases gemeint. Zur Erzeugung des Plasmas wird Prozeßgas in an sich bekannter Weise aus Zuführleitungen in das Gaszuführrohr gedrückt, aus welchem das Prozeßgas dann in den zu beschichtenden Hohlkörper gelangt. Sowohl für die Herstellung als auch für den Betrieb einer Beschichtungsmaschine der hier beschriebenen Art ist ersichtlich die Möglichkeit einer gemeinsamen Gasversorgung für alle vorgesehenen Module von finanziellem (Investitionskosten) und technischem Interesse.

Vorteilhaft ist es auch, wenn für beide Module (oder für die größere Anzahl von Modulen) eine gemeinsame Stromversorgung vorgesehen ist. Man kann die Stromversorgung jeweils in die Mitte zwischen zwei Modulen anbringen mit dem Vorteil geringerer Leitungslängen und besserer Schaltungsmöglichkeiten. Die für die Mikrowellenquellen erforderlichen Hochspannungsumschalter sind bekanntlich aufwendig. Wenn sie wechselweise von wenigen Volt auf Kilovoltbereich umschalten, ergeben sich Überschläge, die im laufenden Betrieb beherrscht werden müssen. Je weniger solcher elektrischer Einrichtungen vorgesehen werden müssen, um so besser ist es für die Beschichtungsmaschine. Erfindungsgemäß gilt hier, die Anordnung so vorzusehen, daß sich zum Beispiel bei zwei Einheiten die Mikrowelleneinheiten einander am nächsten liegen. Bei der erfindungsgemäß vorgeschlagenen spiegelbildlichen Anordnung von zwei Einheiten gelingt dies durch die mittige Anordnung der Mikrowelleneinheiten. Das wirkt sich dann auch entsprechend günstig auf die Stromversorgung aus.

Ferner hat sich erfindungsgemäß auch gezeigt, daß es besonders günstig ist, wenn für jeden Hohlkörper der betreffende Mikrowellenresonator als an der Trennwand befestigter Hohlzylinder ausgebildet ist. Nach dem Zusammenfahren der Träger- und Stützplatte einerseits und der Trennwand andererseits zur Bildung einer gasdichten Behandlungskammer und nach dem Evakuieren derselben können sich die Platten über die massiv ausgebildeten Hohlzylinder, die als Resonatoren wirken, besser abstützen. Bei entsprechend stabiler Ausbildung der Hohlzylinder können auch größere Träger- und Stützplatten sowie Trennwände eingesetzt werden, ohne daß Verbiegungen auftreten. Dies erlaubt die Konstruktion von Behandlungskammern unterschiedlichster Dimensionen. Die betreffende Vakuumkammer kann verhältnismäßig leicht aufgebaut sein. Dabei ist zu berücksichtigen, daß bei einem Luftdruck von 1 bar auf eine größere Trennwand mit zum Beispiel einhundert Bearbeitungsplätzen eine Belastung einwirkt, welche der Gewichtskraft von 18 Tonnen entspricht. Mikrowellenresonatoren benötigt man ohnehin. Bildet man diese also als kräftige Hohlzylinder mit einer Blechwandstärke von zum Beispiel 2 - 8 mm aus, dann erfolgt eine günstige Abstützung auf Außenplatten.

Man kann die Hohlkörperträgerplatte erfindungsgemäß auch an einer Seite eines Plattenwenders anbringen, der um eine vertikale Wendeachse schwenkbar ist, und auf der anderen Seite des Plattenwenders ist dann eine zweite Hohlkörperträgerplatte anbringbar. Die Leistung der Maschine wird durch diese Maßnahmen weiter erhöht. Wenn sich nämlich eine Hohlkörperträgerplatte bereits in der Vakuumkammer befindet, steht die andere Hohlkörperträgerplatte gut zugänglich außerhalb der Maschine. Sie kann dann bequem be- und entladen werden. Damit der Ladevorgang (Be- und/oder Entladen) immer von derselben Seite erfolgen kann, können die Trägerplatten um eine Vertikalachse dadurch gedreht werden, daß sie an dem erwähnten Plattenwender anbringbar sind. Mit diesem schwenken sie zum Beispiel um 180°. Dadurch werden die Hohlkörper in die richtige Position für die Beschichtung gebracht.

Weitere Vorteile, Merkmale und Anwendungsmöglichkeiten der vorliegenden Erfindung ergeben sich aus der folgenden Beschreibung bevorzugter Ausführungsformen in Verbindung mit den anliegenden Zeichnungen. Bei diesen zeigen:
- Figur 1: schematisch eine bevorzugte Ausführungsform einer Beschichtungsmaschine mit zwei Modulen, die spiegelbildlich zueinander angeordnet sind, in einem ersten Betriebszustand vor dem Beschickung der Behandlungskammer,
- Figur 2: abgebrochen den oberen Teil der schematischen Maschine gemäß Figur 1, wobei die Gaszuführrohre bereits in die Hohlkörper eingefahren sind,
- Figur 3: eine ähnliche abgebrochene Ansicht wie Figur 2, jedoch in einem weiteren anderen Betriebszustand, bei welchem die aus Trägerplatte und Stützplatte bestehende Einheit in die Behandlungskammer eingefahren ist,
- Figur 4: die perspektivische Gesamtansicht einer bevorzugten Ausführungsform der Beschichtungsmaschine mit zwei Modulen mit Hohlkörperträgerplatten, Antrieben und in der Mitte angeordneten Mikrowelleneinheiten,
- Figur 5: perspektivisch die Rückansicht der Vorrichtung der Figur 4,
- Figur 6: eine isometrische Darstellung des Maschinenrahmens unter teilweise Darstellung der spiegelbildlichen Anordnung der Module,
- Figur 7: eine Vorderansicht des Maschinenrahmens, wenn man gemäß Figur 6 von links vom nach rechts hinten blickt, wobei am rechten und an dem gegenüberliegenden linken Ende des Maschinenrahmens je eine hydraulische Einheit zum Schließen der Behandlungskammer angedeutet sind,
- Figur 8: unter Weglassung des verbindenden Teiles des Maschinenrahmens perspektivisch die Ansicht zweier Module,
- Figur 9: ebenfalls perspektivisch das in Figur 8 gezeigte rechte Modul mit davor angesetzten Mikrowelleneinheiten, und
- Figuren 10a) bis 10e): schematisch jeweils eine Draufsicht auf die Ausführungsform mit dem Plattenwender bei unterschiedlichen Ladepositionen.

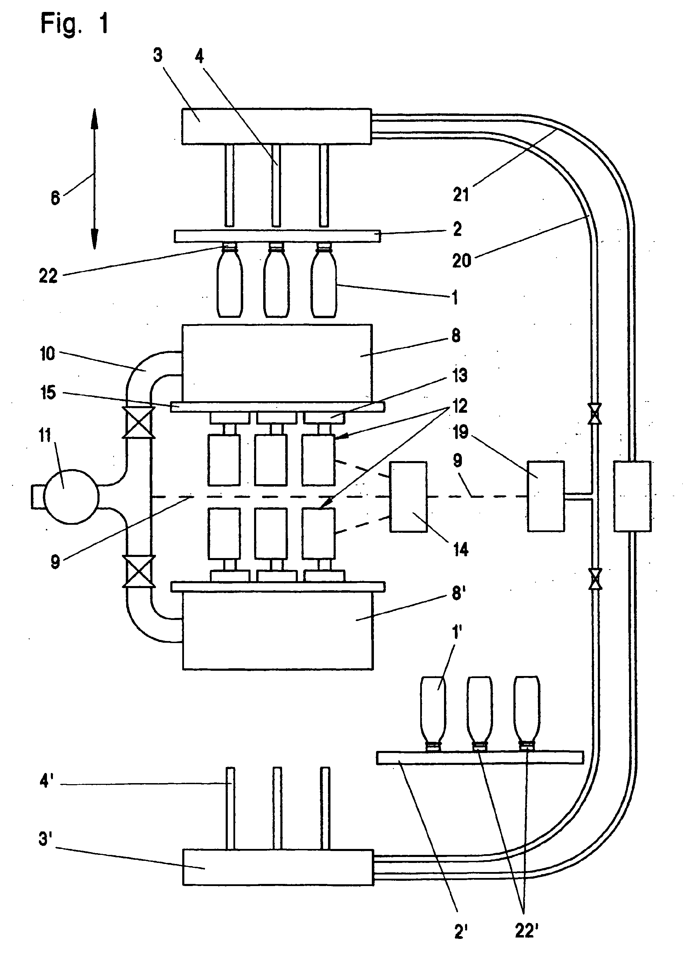

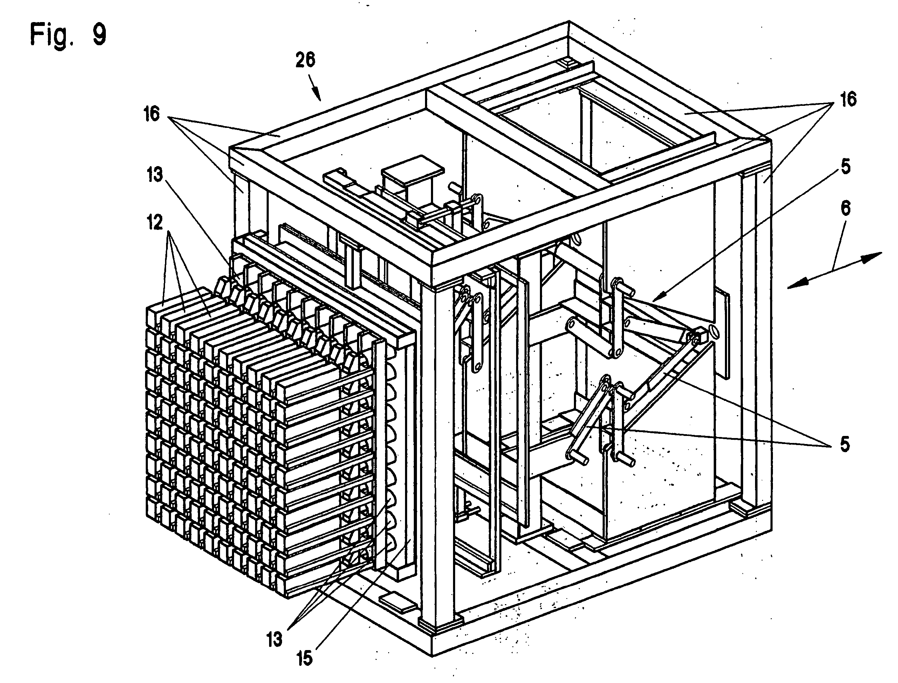

Die schematisch in Figur 1 dargestellte Maschine dient dem gleichzeitigen Beschichten der inneren Oberfläche mehrerer Hohlkörper 1, die hier als Flaschen dargestellt sind. Die Maschine ist in Draufsicht dargestellt, weshalb man auf die schmale obere Längskante einer ebenen Hohlkörperträgerplatte 2 blickt, die vertikal ausgerichtet ist und zum Be- und Entladen nach rechts oder links in horizontaler Richtung bewegbar zu denken ist. An einer ebenfalls vertikal ausgerichteten, ebenen Rohrstützplatte 3 ist eine Reihe von drei horizontal vorstehenden, parallel angebrachten Gaszuführrohren 4 gezeigt. Diese können durch eine am deutlichsten in Figur 9 perspektivisch angedeutete, allgemein mit 5 bezeichnete Hebelmechanik in die entsprechend angeordneten Hohlkörper 1 in Bewegungsrichtung 6 (horizontaler Doppelpfeil) hinein- und aus diesen auch herausgefahren werden.

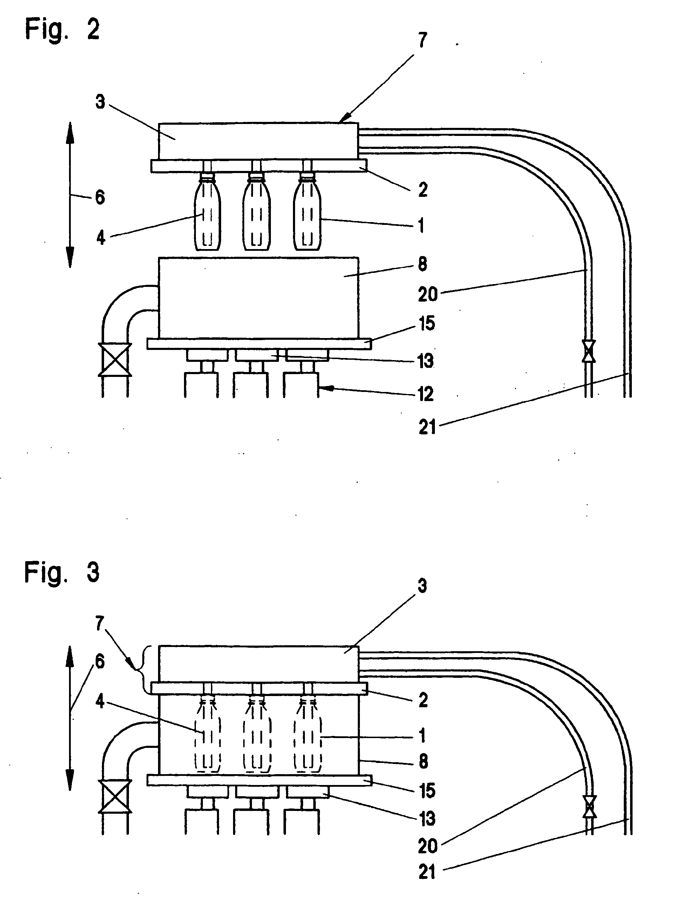

Die aus Trägerplatte 2 und parallel dazu angeordneter Rohrstützplatte 3 bestehende Einheit 7, die in Figur 2 durch das Zusammenfahren zu einer Einheit geworden ist, ist ebenfalls in Bewegungsrichtung 6 in die allgemein mit 8 bezeichnete Behandlungskammer hinein- sowie aus dieser herausbewegbar. Der Aufbau der hier gezeigten Maschine ist doppelt und praktisch bezüglich einer vertikal zu denkenden Mittelebene 9 (gestrichelte Linie in Figur 1) symmetrisch derart aufgebaut, daß die gleichen, vorstehend beschriebenen Maschinenelemente spiegelbildlich nochmals erscheinen. Deshalb sind in der unteren Hälfte der Figur 1 die mit dem Bezugszahlen 1 - 8 gekennzeichneten Elemente apostrophiert. Es handelt sich also auch bei 1' um Hohlkörper, bei 4' um Gaszuführrohre usw. Der Einfachheit halber beschränkt sich die folgende Beschreibung auf eine Maschinenhälfte.

Die jeweilige Behandlungskammer 8, 8' ist über allgemein mit 10 bezeichnete Rohrleitungen und allgemein mit 11 bezeichnete Vakuumaggregate evakuierbar. Das Einstellen, Überwachen und Steuern des jeweiligen Vakuums über Ventile und dergleichen ist dem Fachmann bekannt und wird hier nicht näher beschrieben.

Für jeden Hohlkörper 1 ist die Behandlungskammer 8 mit einer Mikrowelleneinheit 12 mit Resonator 13 bestückt. Eine elektrische Stromversorgung 14 (Figur 1) ist für das gesamte Paket von Mikrowelleneinheiten 12 zuständig und speist diese.

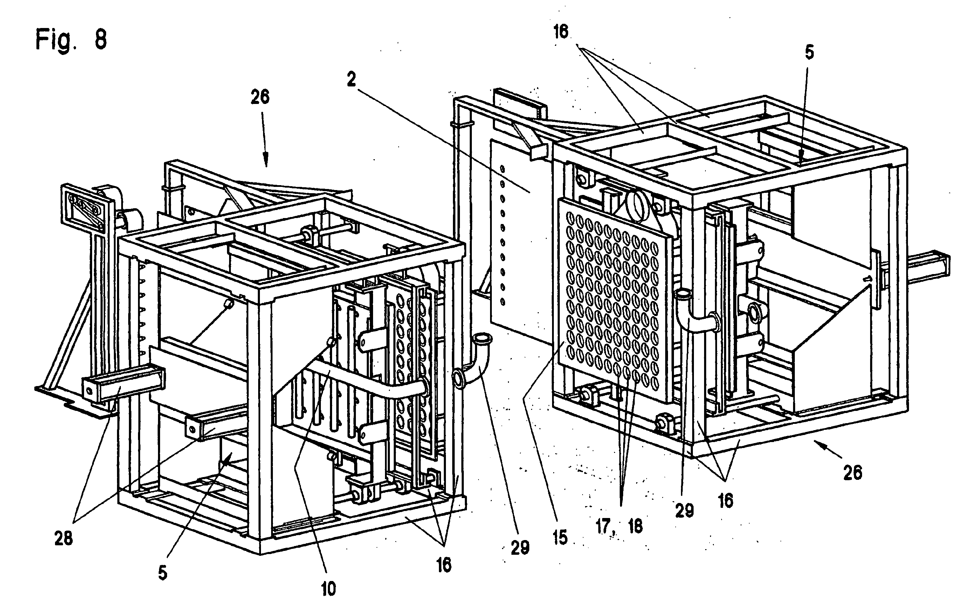

Ebenfalls vertikal ausgerichtet ist eine Trennwand 15, die an dem Maschinenrahmen 16 befestigt ist. Deutlich erkennt man zum Beispiel in Figur 8 rechts diese stationäre Trennwand 15, die mit matrixartig nebeneinander angeordneten Löchern 17 mit Quarzfenstern 18 versehen ist. Die Trennwand 15 dient der Begrenzung der Behandlungskammer 8 (zum Evakuieren) und läßt über ihre Löcher 17, die über Quarzfenster 18 geschlossen sind, die Mikrowellenenergie aus der Einheit 12 in die Behandlungskammer 8 mit dem jeweiligen Hohlkörper 1 hinein.

In Figur 1 ist schließlich mit 19 eine Gasversorgung gezeigt, welche über Rohrverbindungen 20 für die Zufuhr die Rohrstützplatte 3 und damit die an dieser befestigte Anzahl von Gaszuführrohren 4 mit Prozeßgas versorgt. Dieses wird über die anderen Rohrverbindungen 21 für die Abfuhr entleert.

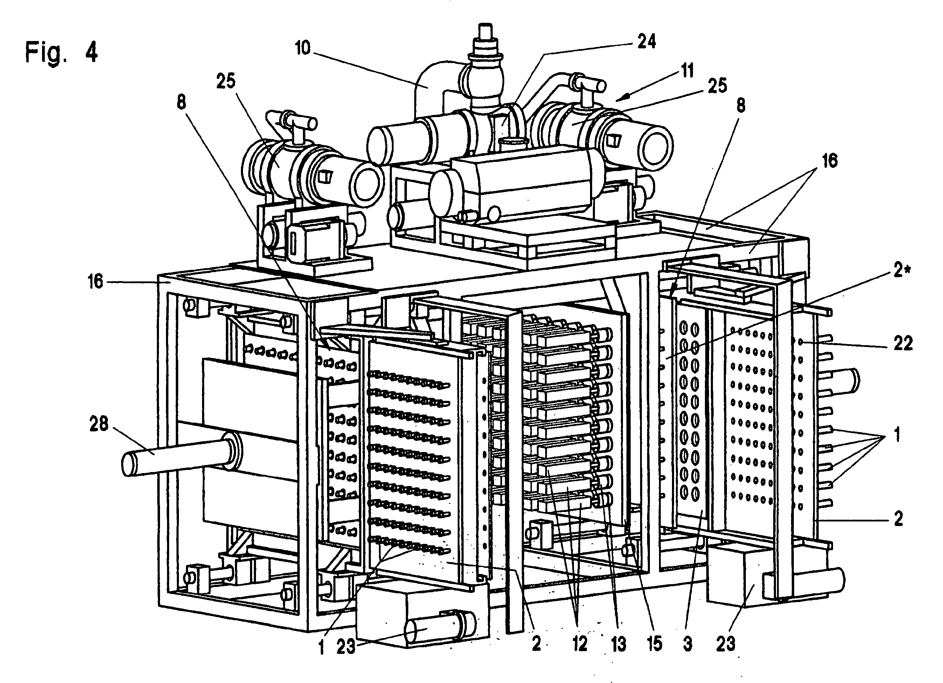

Der Betrieb der Maschine, soweit er sich anhand der Figuren 1 bis 3 beschreiben läßt, erfolgt derart, daß zunächst die Hohlkörperträgerplatte 2 in horizontaler Richtung senkrecht zur Bewegungsrichtung 6 zum Beispiel nach links oder rechts herausgefahren und dort an einer Vielzahl von Befestigungsplätzen 22 für die Hohlkörper 1 bestückt wird. In Figur 4 gezeigte Antriebe 23 verschieben dann die Hohlkörperträgerplatte 2 in Richtung parallel zur Ebene der Trägerplatte 2, damit diese dann die in den Figuren 1 und 2 gezeigte Position einnimmt. Matrixartig sind die Hohlkörper 1 vertikalstehend an der Trägerplatte 2 an den Plätzen 22 Reihe neben Reihe befestigt. Sodann bewegen weitere Antriebe die Rohrstützplatte 3 mit den Gaszuführrohren 4 in Richtung des Doppelpfeils 6 für die Bewegung, so daß sich die Trägerplatte 2 und die Stützplatte 3 einander nähern, wie in Figur 2 dargestellt ist. Die Gaszuführrohre 4 ragen damit in die Hohlkörper 1 hinein, wie in Figur 2 gestrichelt gezeigt ist. Diese aus Trägerplatte 2 und Stützplatte 3 bestehende Einheit 7 fährt danach in die stationäre Behandlungskammer 8 hinein, so daß der Zustand der Figur 3 erreicht ist. Über die Rohrverbindungen 20 werden jetzt die Hohlkörper 1 mit Prozeßgas versorgt, während die zuvor darin befindliche Luft und danach auch das Prozeßgas über die Rohrverbindung für die Abfuhr 21 abgezogen wird. Parallel dazu wird die Behandlungskammer 8 mittels der Vakuumaggregate 11 über die Leitung 10 evakuiert, um den erforderlichen niedrigen Druck außerhalb der Hohlkörper zu erzeugen. Die elektrische Stromversorgung 14 wird eingeschaltet, die Mikrowelleneinheiten 12 mit den Mikrowellenresonatoren 13 eingeschaltet, und das in den Hohlkörpern befindliche Gasgemisch (mit Prozeßgas) wird in den Plasmazustand gebracht. Über die Plasmabildung erfolgt die Beschichtung in an sich bekannter Weise. Danach fährt die Einheit 7 wieder in Richtung des Pfeils 6 nach oben horizontal aus der Behandlungskammer 8 heraus, so daß wieder der Zustand der Figur 2 erreicht ist. Es löst sich dann die Rohrstützplatte 3 mit den Gaszuführrohren 4 zum Erreichen der Position gemäß Figur 1. Danach kann die Hohlkörperträgerplatte 2 horizontal nach links oder rechts senkrecht zur Bewegungsrichtung 6 herausbewegt werden, eine nicht gezeigte Stoßeinrichtung löst die einzelnen Hohlkörper 1 von der Trägerplatte 2 ab. Die Hohlkörper 1 fallen nach unten in einen Behälter, welcher die beschichteten Hohlkörper aufnimmt und dem Füllen usw. zuführt.

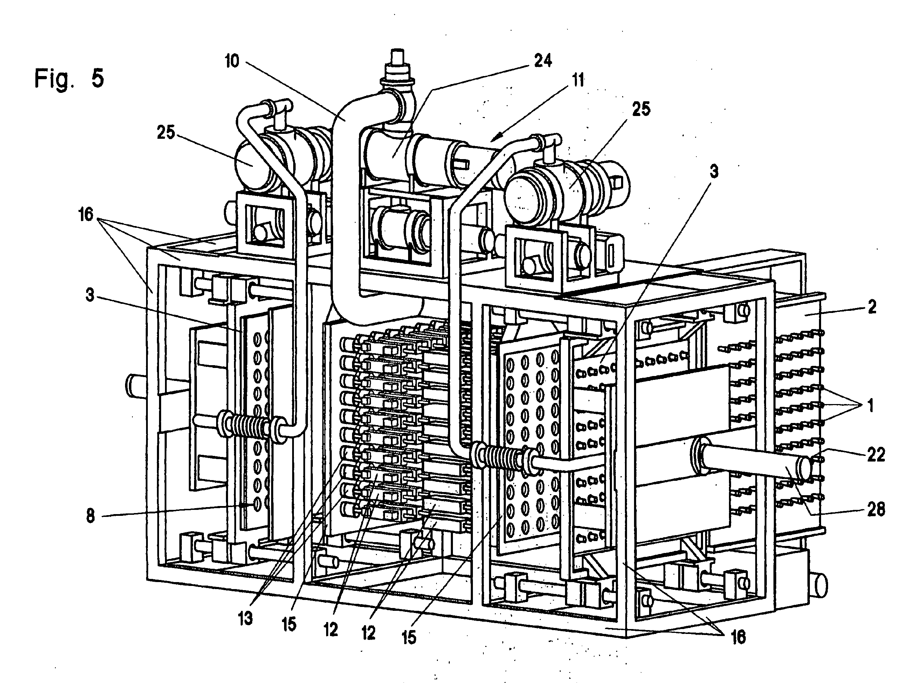

Einzelheiten der Beschichtungsmaschine sind in den Figuren 4 bis 9 näher veranschaulicht. So erkennt man in den Figuren 4 und 5 von dem allgemein mit 11 bezeichneten Vakuumaggregat den in der Mitte angeordneten Hauptpumpensatz 24 und die beiden seitlich davon angeordneten Prozeßpumpensätze 25. Die mit durch diese Pumpen 24, 25 mit Vakuum beaufschlagbaren Behandlungskammern 8 sind zur Verdeutlichung einzelner Maschinenelemente ganz ohne Gehäuse und offen dargestellt.

In der perspektivischen Gesamtansicht gemäß Figur 4 erkennt man von vorn die aus dem Maschinenrahmen 16 mit Hilfe der Antriebe 23 horizontal herausgezogenen Hohlkörperträgerplatten 2, die jeweils 10 x 10 Hohlkörper 1 in waagerechter Orientierung tragen. In dieser Ansicht sieht man auch eine der beiden gerade in die Maschine eingefahrenen Hohlkörperträgerplatten 2*. In der Mitte innerhalb des Maschinenrahmens 16 sitzt das Paket von Mikrowelleneinheiten 12, die in Anzahl und Anordnung den 10 x 10 Hohlkörpern in der gezeigten Matrix entsprechen. Jede Mikrowelleneinheit 12 ist als langer Quader mit quadratischem Querschnitt angedeutet. Hierbei handelt es sich um die Gehäuse, welche die Stromversorgung für das nicht näher dargestellte Magnetron sicherstellen und im Betrieb Wärme erzeugen, weshalb die einzelnen Mikrowelleneinheiten 12 ersichtlich im Abstand voneinander angeordnet sind.

Die gesamte Maschine kann grob in drei Abschnitte eingeteilt werden, wobei die beiden Endabschnitte jeweils ein sogenanntes Modul 26 bilden. Dies bedeutet, daß an jedem der beiden Endplätze eine Trennwand 15, eine Hohlkörperträgerplatte 2 und eine Rohrstützplatte 3 vorgesehen und spiegelbildlich zueinander angeordnet sind. Das dadurch gebildete Modul 26 beinhaltet selbstverständlich auch alle Funktionszubehörteile der beschriebenen und erwähnten wesentlichen Elemente, denn diese Elemente müssen selbstverständlich am Maschinenrahmen 16 befestigt sein, Teile derselben müssen bewegt werden können, und alle Elemente benötigen eine Versorgung für Ihre Funktion. Dazu gehört auch die Hebelmechanik 5, welche die Behandlungskammer 8 zu verschließen und zu öffnen erlaubt. In dem mittleren dritten Abschnitt befinden sich die matrixartig angeordneten Mikrowelleneinheiten 12, welche damit in einem gemeinsamen Klimaraum mit einer nicht näher bezeichneten Kühlversorgung untergebracht sind. Man kann sich vorstellen, daß dieser Kühlraum in Figur 9 links von dem würfelartigen Maschinenrahmen 16 beginnt und das gesamte Paket der Mikrowelleneinheiten 12 mit Kühlfluid umspült.

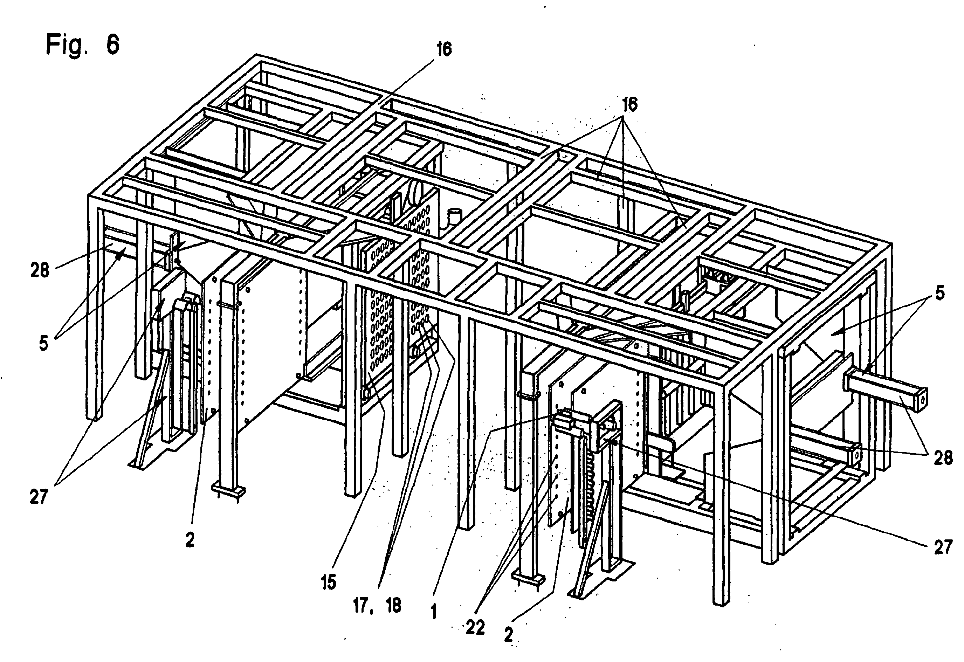

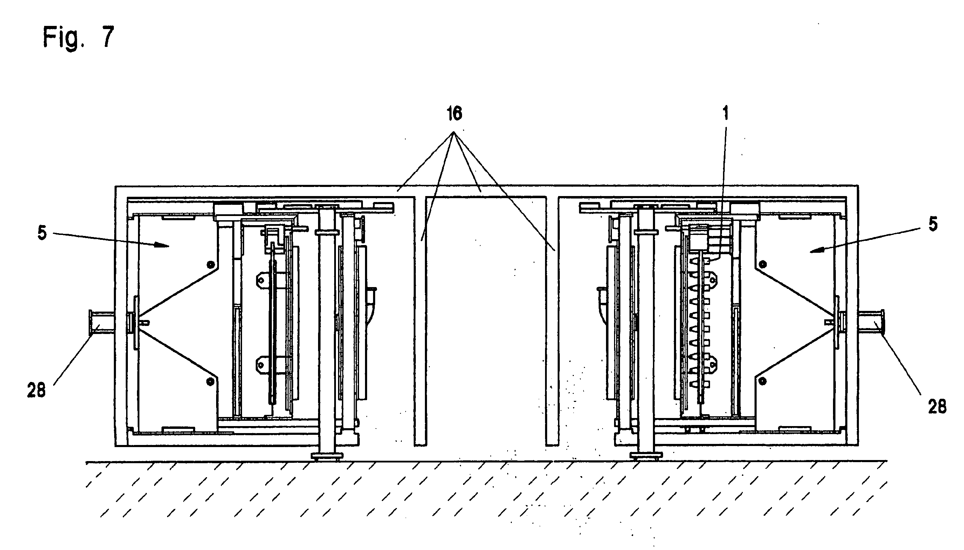

In den Figuren 6 und 7 sind für den spiegelbildlichen Aufbau der gesamten Vorrichtung mit den drei Abschnitten zahlreiche Einzelheiten weggelassen und der Übersichtlichkeit wegen praktisch nur noch der Maschinenrahmen 16 mit den beiden Hohlkörperträgerplatten 2 für die Hohlkörper 1 gezeigt. Der spiegelbildliche Aufbau springt ins Auge. Außerdem erkennt man an jeder der beiden Trägerplatten 2 jeweils eine Bestückungseinheit 27 für die Hohlkörper 1. Letztere werden gerade in die jeweilige Trägerplatte 2 eingeladen. Figur 7 zeigt maßstabsgerecht die Vorderansicht der in Figur 6 gezeigten Anordnung. Man erkennt am rechten und linken Ende die beiden hydraulischen Stempel 28 für die Hebelmechanik 5. Diese bewirken das Öffnen und Schließen der beiden Behandlungskammern 8.

In Figur 8 sieht man links das erste Modul 26 und rechts das ebenfalls mit 26 bezeichnete zweite Modul. Nur Teile des Maschinenrahmens 16 (in Würfelform) sind dargestellt, um die Veranschaulichung zu verdeutlichen. Die jeweilige Behandlungskammer 8 ist in geöffnetem Zustand gezeigt. Deshalb sind auch die Rohrleitungen 10 zum Abpumpen und Erzeugung des Vakuums abgebrochen dargestellt. Man erkennt sogar zwei Krümmer 29, die quasi in der Luft hängen. Man kann sich aber leicht vorstellen, daß im Betrieb beim Schließen der Behandlungskammern 8 auch diese Rohrleitungen 10 aufeinander zu gefahren und geschlossen werden. In der rechten Hälfte der Figur 8 sieht man deutlich die stationäre Trennwand 15 mit den 10 x 10 kreisförmigen, matrixartig angeordneten Löchern 17. In diesen Löchern befinden Quarzfenster 18, welche die Mikrowelleneinkopplung von der eigentlichen, evakuierbaren Behandlungskammer 8 mechanisch trennen.

Nimmt man das rechte Modul der Figur 8 heraus, fährt man die Hohlkörperträgerplatte 2 in den Betriebszustand hinein und setzt man vorn auf die stationäre Trennwand 15 den Block der Mikrowelleneinheiten 12 auf, dann erhält man die perspektivische Ansicht des rechten Moduls 26 in Figur 9. Hier erkennt man deutlicher die Hebelmechanik 5 zum Öffnen und Schließen der Behandlungskammer 8. Die hydraulischen Stempel 28 für den Bewegungsantrieb sind hier weggelassen.

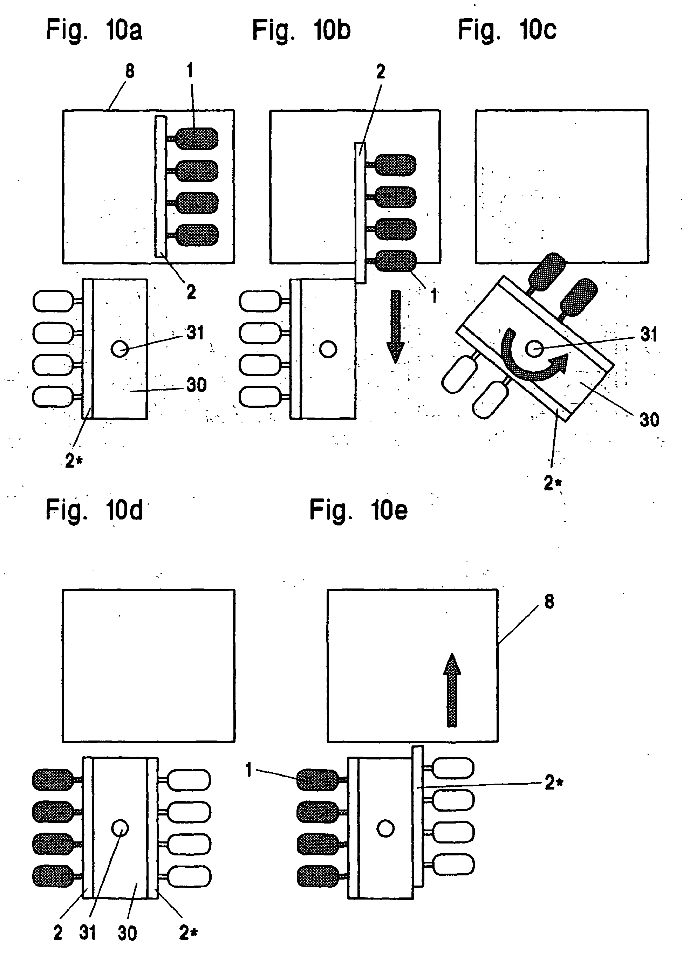

Figur 10a) zeigt diejenige Betriebsposition, in welcher die Hohlkörperträgerplatte 2 zum Beschichten der Hohlkörper 1 in die Behandlungskammer 8 eingefahren ist. Außerhalb der Behandlungskammer 8 (in Figur 10a) unterhalb), ist ein Plattenwender 30 um eine vertikale Wendeachse 31 schwenkbar angeordnet und haltert die andere Hohlkörperträgerplatte 2* mit gerade sich im Beschickungsprozeß mit Hohlkörpern befindlichem Zustand.

Figur 10b) zeigt, wie die innen beschichteten Hohlkörper 1 mit Hilfe der Trägerplatte 2 gerade anfangen, sich gemäß dem nach unten zeigenden Pfeil nach vorn aus der Behandlungskammer 8 herauszubewegen. Die Trägerplatte 2 kommt danach an die rechte Seite des Plattenwenders 30 zu liegen und wird dort verklinkt.

Figur 10c) zeigt den Betriebszustand, in welchem der Plattenwender 30 um seine Wendeachse 31 in Richtung des gebogenen Pfeils geschwenkt wird, so daß die nicht beschichteten Hohlkörper in die in Figur 10d) gezeigte Position kommen. Die Hohlkörperträgerplatte 2* befindet sich bei der Draufsicht auf den Plattenwender 30 rechts, so daß sie vom Plattenwender 30 abgelöst und in dem dargestellten Betriebszustand der Figur 10e) in Richtung des nach oben zeigenden Pfeils in die Behandlungskammer 8 eingefahren werden kann. Inzwischen bleibt der Plattenwender 30 außen stehen, und man kann die beschichteten Hohlkörper 1 abnehmen und durch unbeschichtete ersetzen. Nach dem Beschichten der auf der Trägerplatte 2* sitzenden Hohlkörper ist dann wieder die Position der Figur 10a) erreicht. Der Betriebsablauf wiederholt sich.

### Bezugszeichenliste:

- 1: Hohlkörper
- 2,2',2*: Hohlkörperträgerplatte
- 3: Rohrstützplatte
- 4: Gaszuführrohr
- 5: Hebelmechanik
- 6: Bewegungsrichtung
- 7: Einheit aus 2 und 3
- 8: Behandlungskammer
- 9: gedachte vertikale Ebene
- 10: Rohrleitung
- 11: Vakuumaggregate
- 12: Mikrowelleneinheit
- 13: Mikrowellenresonator
- 14: elektrische Stromversorgung
- 15: stationäre Trennwand
- 16: Maschinenrahmen
- 17: Loch in der Trennwand 15
- 18: Quarzfenster
- 19: Gasversorgung
- 20: Rohrverbindungen für die Zufuhr
- 21: Rohrverbindungen für die Abfuhr
- 22: Befestigungsplatz für Hohlkörper
- 23: Antrieb
- 24: Hauptpumpensatz
- 25: Prozeßpumpensatz
- 26: Modul
- 27: Bestückungseinheit
- 28: hydraulischer Stempel
- 29: Rohrkrümmer
- 30: Plattenwender
- 31: Wendeachse

## Patentansprüche

1. Maschine zum gleichzeitigen Beschichten der inneren Oberfläche mehrerer Hohlkörper (1), die auf einer im wesentlichen ebenen Hohlkörperträgerplatte (2) so gehalten sind, daß jeweils ein an einer etwa ebenen Rohrstützplatte (3) befestigtes Gaszuführrohr (4) für Prozeßgas in den Hohlkörper (1) einführbar ist und die aus Träger- (2) und parallel dazu angeordneter Stützplatte (3) bestehende Einheit (7) in die jeweilige evakuierbare Behandlungskammer (8) hinein- sowie aus dieser herausbewegbar ist, wobei die Behandlungskammer (8) für jeden Hohlkörper (1) mit einer Mikrowelleneinheit (12) mit Resonator (13) bestückt ist, **dadurch gekennzeichnet, daß**
1. die Hohlkörperträgerplatte (2) mit matrixartig nebeneinander angeordneten Befestigungsplätzen (22) und die Rohrstützplatte (3) mit zu diesen Befestigungsplätzen (22) jeweils korrespondierend angeordneten Gaszuführrohren (4) vertikal ausgerichtet sind,
2. ebenfalls vertikal ausgerichtet eine Trennwand (15) mit entsprechend passend matrixartig nebeneinander angeordneten Löchern (17) mit Quarzfenstern (18) am Maschinenrahmen (16) befestigt ist,
3. die Träger- (2) und die Stützplatte (3) mit einem Antrieb (23) für deren horizontale Bewegung in die Maschine hinein und zum Be- und Entladen aus der Maschine heraus vorgesehen ist,
4. die Trennwand (15), die Hohlkörperträgerplatte (2) und die Rohrstützplatte (3) mit ihren Funktionszubehörteilen (5, 10, 11, 23-25) ein erstes Modul (26) bilden,
5. spiegelbildlich zu dem ersten Modul (26) ein zweites Modul (26) entsprechenden Aufbaues am Maschinenrahmen (16) befestigt ist und
6. daß sich die matrixartig angeordneten Mikrowelleneinheiten (12) zwischen den Modulen (26) befinden.

2. Maschine nach Anspruch 1, **dadurch gekennzeichnet, daß** für beide Module (26) eine gemeinsame Kühlvorrichtung vorgesehen ist.

3. Maschine nach Anspruch 1 oder 2, **dadurch gekennzeichnet, daß** für beide Module (26) eine gemeinsame Gasversorgung (19) vorgesehen ist.

4. Maschine nach einem der Ansprüche 1 bis 3, **dadurch gekennzeichnet, daß** für beide Module (26) eine gemeinsame Stromversorgung (14) vorgesehen ist.

5. Maschine nach einem der Ansprüche 1 bis 4, **dadurch gekennzeichnet, daß** für jeden Hohlkörper (1) der betreffende Mikrowellenresonator (13) als an der Trennwand (15) befestigter Hohlzylinder ausgebildet ist.

6. Maschine nach einem der Ansprüche 1 bis 5, **dadurch gekennzeichnet, daß** die Hohlkörperträgerplatte (2) an einer Seite eines Plattenwenders (30) anbringbar ist, der um eine vertikale Wendeachse (31) schwenkbar ist, und daß auf der anderen Seite des Plattenwenders (30) eine zweite Hohlkörperträgerplatte (2*) anbringbar ist.

## Claims

1. A machine for simultaneously coating the internal surface of a plurality of hollow bodies (1) which are held on a substantially flat hollow body carrier plate (2) in such a way that a respective gas feed tube (4) for process gas which is secured to a substantially flat tube support plate (3) can be introduced into the hollow body (1) and the unit (7) comprising the carrier plate (2) and the support plate (3) arranged parallel thereto can be moved into and out of the respective evacuatable treatment chamber (8), wherein the treatment chamber (8) for each hollow body (1) is equipped with a microwave unit (12) with resonator (13),
**characterised in that**
1. the hollow body carrier plate (2) with fixing places (22) arranged in mutually juxtaposed matrix-like relationship and the tube support plate (3) with gas feed tubes (4) arranged in corresponding relationship with respective ones of said fixing places (22) are oriented vertically,
2. also vertically oriented a separating wall (15) with holes (17) arranged in correspondingly matching matrix-like mutually juxtaposed relationship and having quartz windows (18) is fixed to the machine frame (16),
3. the carrier plate (2) and the support plate (3) are provided with a drive (23) for horizontal movement thereof into the machine and out of the machine for loading and unloading,
4. the separating wall (15), the hollow body carrier plate (2) and the tube support plate (3) with their functional accessories (5, 10, 11, 23-25) form a first module (26),
5. fixed to the machine frame (16) in mirror-image relationship with the first module (26) is a second module (26) of corresponding structure, and
6. the microwave units (12) arranged in matrix-like configuration are disposed between the modules (26).

2. A machine according to claim 1 **characterised in that** a common cooling arrangement is provided for both modules (26).

3. A machine according to claim 1 or claim 2 **characterised in that** a common gas supply (19) is provided for both modules (26).

4. A machine according to one of claims 1 to 3 **characterised in that** a common power supply (14) is provided for both modules (26).

5. A machine according to one of claims 1 to 4 **characterised in that** for each hollow body (1) the microwave resonator (13) in question is in the form of a hollow cylinder fixed to the separating wall (15).

6. A machine according to one of claims 1 to 5 **characterised in that** the hollow body carrier plate (2) can be mounted to one side of a plate turner (30) which is pivotable about a vertical turning axis (31) and that a second hollow body carrier plate (2*) can be mounted on the other side of the plate turner (30).

## Revendications

1. Machine servant à revêtir simultanément la surface intérieure de plusieurs corps creux (1), qui sont maintenus sur une plaque de support de corps creux (2) sensiblement plane, de sorte que respectivement un tuyau d'amenée de gaz (4) pour le gaz de traitement fixé sur une plaque d'appui de tuyau (3) à peu près plate peut être introduit dans le corps creux (1) et l'unité (7) constituée d'une plaque de support (2) et d'une plaque d'appui (3) disposée parallèlement à celle-ci peut se déplacer à l'intérieur et à l'extérieur de chaque chambre de traitement (8) pouvant être mise sous vide, la chambre de traitement (8) pour chaque corps creux (1) étant équipée d'une unité à micro-ondes (12) dotée d'un résonateur (13), **caractérisée en ce que**
1. la plaque de support de corps creux (2) comprenant des positions de fixation (22) juxtaposées à la façon d'une matrice et la plaque d'appui (3) comprenant des tuyaux d'amenée de gaz (4) disposés de manière respectivement correspondante par rapport à ces positions de fixation (22) sont orientées verticalement,
2. une cloison (15) comprenant des trous (17) juxtaposés à la façon d'une matrice avec une adaptation correspondante et dotés de fenêtres en quartz (18) est fixée sur le cadre de machine (16) en étant également orientée verticalement,
3. la plaque de support (2) et la plaque d'appui (3) sont pourvues d'un entraînement (23) pour se déplacer horizontalement à l'intérieur de la machine et destiné au chargement et au déchargement à l'extérieur de la machine,
4. la cloison (15), la plaque de support de corps creux (2) et la plaque d'appui de tuyau (3) forment avec leurs accessoires opérationnels (5, 10, 11, 23 à 25) un premier module (26),
5. un second module (26) de structure correspondante est fixé sur le cadre de machine (16) de façon symétrique par rapport au premier module (26) et
6. les unités à micro-ondes (12) disposées à la façon d'une matrice se situent entre les modules (26).

2. Machine selon la revendication 1, **caractérisée en ce qu'**un dispositif de refroidissement commun est prévu pour les deux modules (26).

3. Machine selon la revendication 1 ou 2, **caractérisé en ce qu'**une alimentation en gaz (19) commune est prévue pour les deux modules (26).

4. Machine selon l'une quelconque des revendications 1 à 3, **caractérisée en ce qu'**une alimentation en courant (14) commune est prévue pour les deux modules (26).

5. Machine selon l'une quelconque des revendications 1 à 4, **caractérisée en ce que** pour chaque corps creux (1), le résonateur micro-ondes (13) correspondant est conçu comme un cylindre creux fixé sur la cloison (15).

6. Machine selon l'une quelconque des revendications 1 à 5, **caractérisée en ce que** la plaque de support de corps creux (2) peut être aménagée sur une face d'un retourneur de plaque (30), qui peut pivoter autour d'un axe de retournement vertical (31), et **en ce qu'**une seconde plaque de support de corps creux (2*) peut être aménagée sur l'autre face du retourneur de plaque (30).
